Europäisches Patentamt

European Patent Office

Office européen des brevets

(19)

(11) EP 1 045 441 A2

(12) **EUROPEAN PATENT APPLICATION**

(43) Date of publication:
18.10.2000 Bulletin 2000/42

(51) Int. Cl.$^7$: **H01L 23/525**

(21) Application number: 00107782.5

(22) Date of filing: 11.04.2000

(84) Designated Contracting States:
**AT BE CH CY DE DK ES FI FR GB GR IE IT LI LU
MC NL PT SE**
Designated Extension States:
**AL LT LV MK RO SI**

(30) Priority: **14.04.1999 US 291496**

(71) Applicant:
**INTERNATIONAL BUSINESS MACHINES
CORPORATION
Armonk, NY 10504 (US)**

(72) Inventors:
• **Chandrasekhar, Narayan
Hopewell Junction, NY 12533 (US)**
• **Gabriel, Daniel
Jamaica Estates, NY 11432 (US)**

(74) Representative:
**Teufel, Fritz, Dipl.-Phys.
IBM Deutschland Informationssysteme GmbH,
Intellectual Property,
Pascalstrasse 100
70548 Stuttgart (DE)**

(54) **Slotted contacts for minimizing the voltage required to electrically blow fuses**

(57)     Electrical fuses buried inside a multi-layered structure are programmed by remotely applying a voltage to the fuses from the uppermost layer of the structure. The fuse pads, which are integral to the fuse, are stacked with conductive pads to provide an electrical path between the fuse and the uppermost layer. The dimensions of the conductive pads are equivalent to the fuse pads. This configuration significantly reduces the voltage required to program electrical fuses buried inside a multi-layered structure. In a second embodiment of the invention, the conductive pads are replaced with conductive stripes, each stripe shorting one of the two pads of each fuse. By stacking the stripes one on top of the other, a conductive vertical wall is formed from the layer where the fuses are located to the top surface. This configuration reduces the voltage required to blow selected ones of the fuses to an even lower value.

Figure 5

**Description**

Field of the Invention

This invention is related to an array of electrically blown fuses, and more particularly, to conductive contacts and slotted stripes designed to lower the resistance between the contacts and the fuse, thereby minimizing the magnitude of an externally applied voltage set to program the fuses.

Background of the invention

Fuses and anti-fuses have been widely used in the semi-conductor industry, particularly in integrated circuit (IC) chips and multi-layered second level packages. These elements have been employed for a variety of purposes, such as for activating redundancy units, e.g., in DRAMs, for personalizing IC chips or multi-level modules, etc. Fuses may be electrically blown or programmed by a laser beam. Both techniques have been used in the art with equal success.

Programming electrically blown fuses and anti-fuses (the anti-fuses will hereinafter be combined with fuses in a single category) oftentimes requires a substantial voltage. This requirement is a distinct drawback since an externally applied voltage having a high value may easily damage the devices surrounding the fuse array. This is particularly true when all the devices forming the IC are tightly packed together, as is the case in DRAMs. Accordingly, a trend has evolved in the semiconductor industry for lowering the magnitude of the voltage to program fuses, prompting a need to redesign the fuse in order to minimize the externally applied voltage necessary to blow the fuse without inflicting damage to surrounding devices.

In another aspect, fuses that are arranged in a linear configuration take up a significant amount of chip real estate, particularly since each fuse requires a latch for programming purposes. In an array configuration, the number of latches may be significantly reduced. However, a dense fuse layout increases the wiring resistance on account of the very small vias in series that connect the buried fuses deep inside the chip to the uppermost layer of the multi-layered structure.

The voltage needed to electrically activate a fuse depends, among several factors, on the total resistance of the fuse electrical path that connects the fuse to interconnection wires. This resistance is made of the resistance of the actual fuse and that of the wiring and contacts that connect the fuse to the power source. Once the fuse geometry is defined, it is important to evaluate the resistance of the wiring to the fuse.

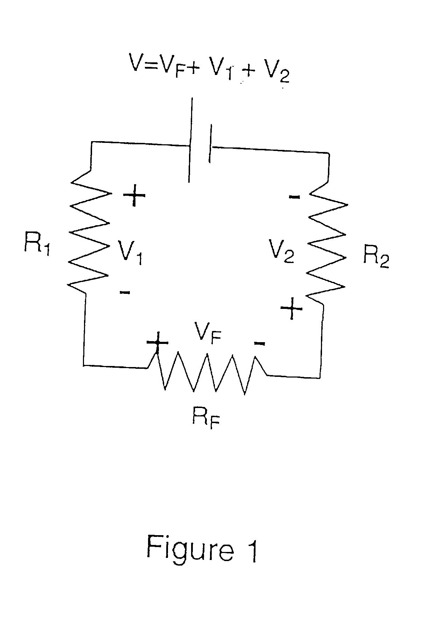

Referring to Figure 1, there is shown a schematic diagram of an electrical model representing a conventional fuse contacting two vias. Each via respectively consists of a combination of serially connected individual vias traversing the various layers forming the structure.

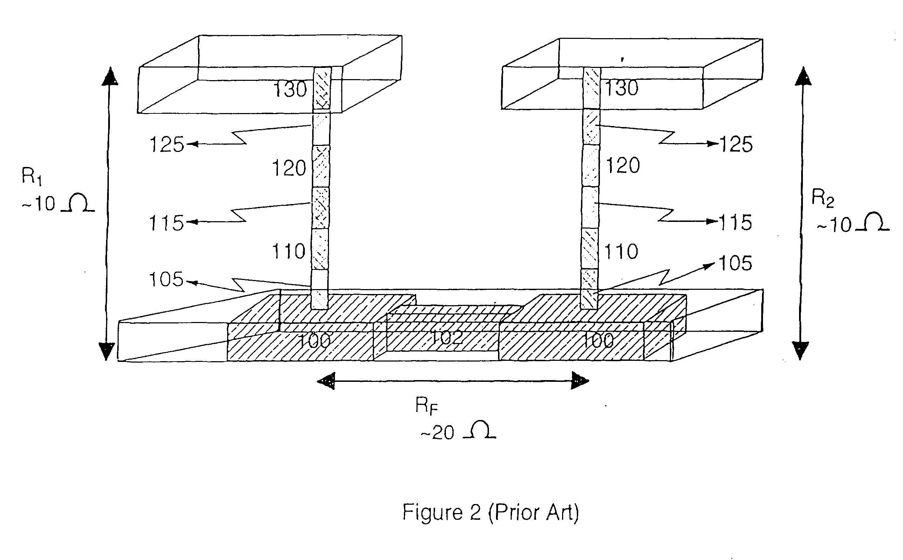

The electrical model shown in Figure 1 will be better understood when taken in conjunction with the physical layout illustrated in Figure 2. Figure 2 shows a typical electrical fuse element formed by fuse link 102 connected at each end to a fuse pad 100. The fuse is buried several layers below the top level and the voltage to be applied to the fuse must, therefore, span through several levels of wiring. In this case, 110, 120 and 130 represent three wiring levels, and vias (or studs) 105, 115 and 125 connect the wiring levels to each other. By way of example, for a device built in the 0.25 um technology, the studs would typically be of the order of 0.25 um. The landing pads are, preferably, made as small as possible, perhaps 0.5 um on each side, so as to be in tune with the minimum features allowed in the technology. In DRAMs, wherein Al and W are typically used, the column of studs have a resistance of about 10 $\Omega$. Another 10 $\Omega$ are provided by the second contact for the return path, making the total wiring resistance of the order of 20 $\Omega$.

The electrical path consisting of vias 130, 125, 120, 115 and 110 are serially connected to each other. The bottommost via 110 makes contact with fuse pad 100, which is shown connected to fuse link 102. The second end of fuse link 102 terminates in the second fuse pad 100, which in turn makes contact to a string of vias serially attached to each other, i.e., 115, 120, 125 and 130. The first and second serial combination of vias 130, 125, 120, 115 and 110 are respectively represented in Figure 1 by resistances $R_1$ and $R_2$. The resistance of the fuse, consisting of fuse pads 100 and fuse link 102, is represented in Figure 1 by resistance $R_f$. V embodies the external voltage applied to program the fuse. Using the typical values described above, i.e., $R_1 = R_2 = 10\ \Omega$, and $R_f = 20\ \Omega$. Thus, $V_1 + V_2 = V_f$, wherein $V_1$ is the voltage drop across $R_1$, $V_f$ is the volt drop across the fuse, and $V_2$, the voltage drop across the second set of vias. Thus, the externally applied voltage needed to program the fuse must be $2V_f$.

In a typical fuse arrangement, the minimum dimensions used in the formation of vias, namely, 0.25 μm increases the resistance to about 10Ω such that, in order to electrically blow the fuse buried inside the IC, a substantial voltage, e.g., 5-15 volts, must be externally applied across the fuse link from a remote location, i.e., the uppermost level of the IC. This problem is compounded when the number of interconnection wiring layers increases, which, in turn leads to a corresponding increase of two additional vias or studs per layer, adding 1-2Ω per layer. Moreover, only half the applied voltage is available for blowing the fuses, as will be explained hereinafter. Devices in the vicinity of the fuses will see a higher voltage. This can cause a reliability concern due to dialelectric breakdown caused by the high voltage, which in turn may introduce degradation of the devices.

Thus, the problem remains of how to forestall reliability problems, which necessitates selecting a universal 'worst case' voltage in order to account for any and all fuse positions anywhere within the IC. It further requires that a uniform external voltage be simultaneously applied to program all the fuses to make this voltage universally applicable to all fuses within the structure.

Objects of the Invention

Accordingly, it is an object of the present invention to stack a plurality of conductive pads on top of each fuse pad forming a fuse buried deep inside a multi-layered structure to linking each of said fuse pads to predetermined points at the topmost layer of the structure.

It is another object of the invention to short by way of a conductive stripe one of two pads of each fuse, wherein the fuses are arranged in an array formation, leaving the other available for programming the fuse individually and further stacking the conductive stripes one on top of the other to couple the fuses forming the array from their position deep inside a multi-layered structure to selected points on the topmost layer.

It is yet another object of the invention to minimize the magnitude of the externally applied voltage required to electrically blow selected fuses by having these conductive pads have dimensions which approximate the dimensions of the fuse pads.

It is still another object of the invention to substantially reduce the real estate penalty for implementing redundancy circuitry by reducing the area taken by the fuse array.

It is a further object to have the conductive stripes form a 'wall' linking all the fuse links to be shorted, wherein the wall extends vertically upwards to the uppermost layer of the chip or package.

Summary of the Invention

In a first aspect of the invention, there is provided an array of programmable fuses in a multi-layered structure, each of the programmable fuses having a fuse link terminating in a fuse pad at each end thereof, the array is characterized in that conductive stripes respectively short one of the fuse pads in each of the programmable fuses. The conductive stripes extend through each of said layers and provide a continuous and uniform conductive path linking the shorted fuse pads to a top layer of the multi-layered structure.

In a second aspect of the invention there is provided a fuse buried inside a multi-layered structure, the fuse having a fuse link terminating in a fuse pad at each end thereof, the fuse is characterized in that conductive pads with dimensions equivalent to the fuse pads are stacked on the fuse pads to couple the fuse pads to an upper layer of the multi-layered structure.

In a third aspect of the invention, there is provided an arrangement of co-planar programmable fuses buried in a multi-layered structure, the programmable fuses are configured in an array, the array of programmable fuses is positioned between orthogonally disposed contacts, each of the programmable fuses having a fuse link terminating in fuse pads, the arrangement of co-planar programmable fuses is characterized in that each row of the fuses is connected to conductive stripes at one end of each of the rows and is also connected to orthogonally positioned conductive stripes at a second end of the fuses, such that only one of the fuses is positioned between any two of the orthogonal conductive stripes.

The arrangement of co-planar programmable fuses is further characterized by having each of the fuses programmed by applying a voltage across a pair of the orthogonal conductive stripes connecting respective pads of the fuse.

Brief Description of the Drawings

The accompanying drawings, which are incorporated herein and which constitute a part of the specification illustrate presently preferred embodiments of the invention which, together with the detailed description given below serve to explain the principles of the invention.

Fig. 1 is a schematic diagram of an electrical model applicable to a conventional fuse having a plurality of serially connected vias.

Fig. 2 shows a conventional electrical fuse connected through various levels of wiring by way of vias or studs, to the topmost layer of an IC chip or multi-layered package.

Fig. 3 shows conductive pads weaving their way through various layers to an uppermost layer of a IC chip or a multi-layered package, in accordance with a first embodiment of the present invention.

Fig. 4 shows one pad of each fuse shorted together to form a common bus, this bus extending to the topmost layer of the IC or multi-layered package, in accordance with another embodiment of the present invention.

Fig. 5 illustrates fuses arranged in an array configuration with one pad shorted together forming a bus, wherein the bus forms a vertical wall which extends to the topmost layer of the chip or multi-layered package, in accordance with a third embodiment of the invention.

Detailed Description of the Invention

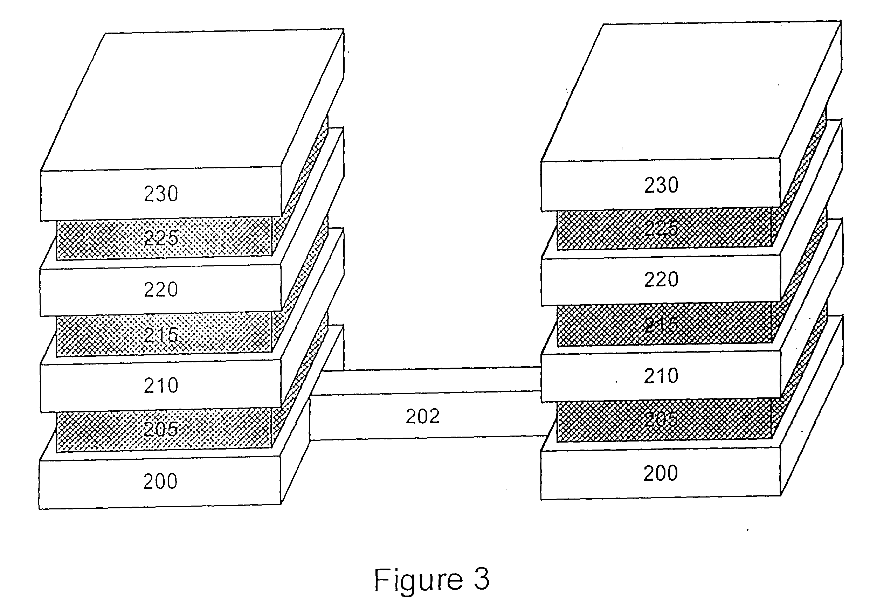

In a first embodiment of the invention shown in Figure 3, conductive pads weaving their way through various layers to an uppermost layer of a IC chip or a multi-layered package are shown, with the direct result that the wiring resistance with respect to a conventional arrangement depicted in Figure 2 is substantially reduced.

Fuse link 202 is depicted terminating in two pads 200, exactly as in any conventional fuse. However, the wiring to the pads is now tailored to offer the minimum electrical resistance. Standard vias or studs are replaced with larger conductive pads not different from the pads on the wiring levels. The groundrules are now dictated more by the largest allowable dimensions at any given wiring level rather than by the smallest permitted dimensions. Pads 210, 220 and 230 show the pads at each wiring level, while 205, 215 and 225 represent pads that are used in the stud level. In this example, pads 200, 205, 210, 215, 220, 225 and 230 are all nominally 2 um square. The thickness of the wiring and via levels are typically 0.2 to 0.5 um. The uppermost level of metal, i.e., 230, has a thickness that ranging from 0.5 - 1.5 um. There may be small differences in pad sizes at the via levels versus the wiring levels to accommodate overlay tolerances between levels during the lithographic process. For the dimensions described in this example, the resistance of each wire down to the fuse is only 0.1 $\Omega$. This makes the total wiring resistance for both contacts only 0.2 $\Omega$, a factor of 100 smaller than what is considered the norm. For a conventional fuse having a resistance in the order of 20 $\Omega$, it represents a significant reduction in the magnitude of the externally applied voltage used to blow the fuse. When translated to the electrical model shown in Figure 1, $R_1 \approx R_2 \approx 0.1$. Therefore, the voltage drop across the various component of the electrical is $V_1 \approx V_2 \approx 0$. Thus, the external voltage approximates $V_f$, or half the original applied voltage required in the prior art described with reference to Figure 2. The voltage is reduced by almost a factor of two for the example shown in Figure 3.

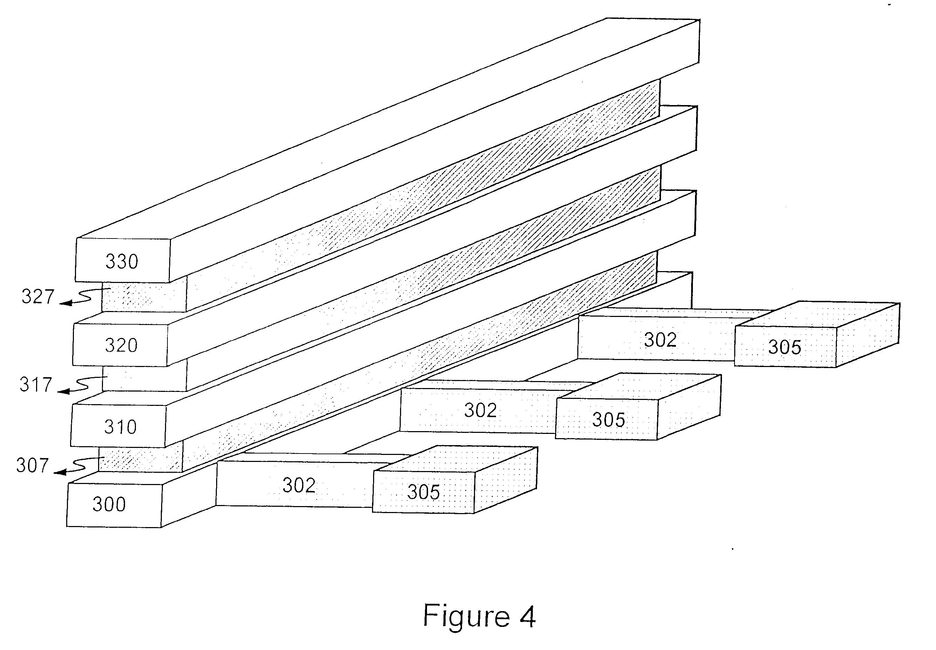

The second embodiment shown in Figure 4 illustrates the case where one of the terminals (i.e., fuse pads) of all the fuses are shorted together. These common terminals are now linked by a large bus, and once again the stud level is replaced by a wire, not unlike that found in a wiring layer. The fuse links 302 are connected to individual pads 305 at one end of the fuse link, and to a common wire 300, at the other end. Wires 310, 320 and 330 are typically 2 um wide and have the minimum length required to connect it to an external pad in the uppermost level. The via levels 307, 317 and 327 are replaced by wires, also nominally 2 um wide. The thickness of the wiring and via levels typically vary between 0.2 and 0.5 um. The last level of metal, in this case 330, can be 0.5 to 1.5 um thick. As in the case of Figure 3, small differences in width between the wiring and the via levels can be present to accommodate the lithography issues associated with overlay tolerances. Pads 305 are connected to the external pads with structures similar to those illustrated in Figure 3.

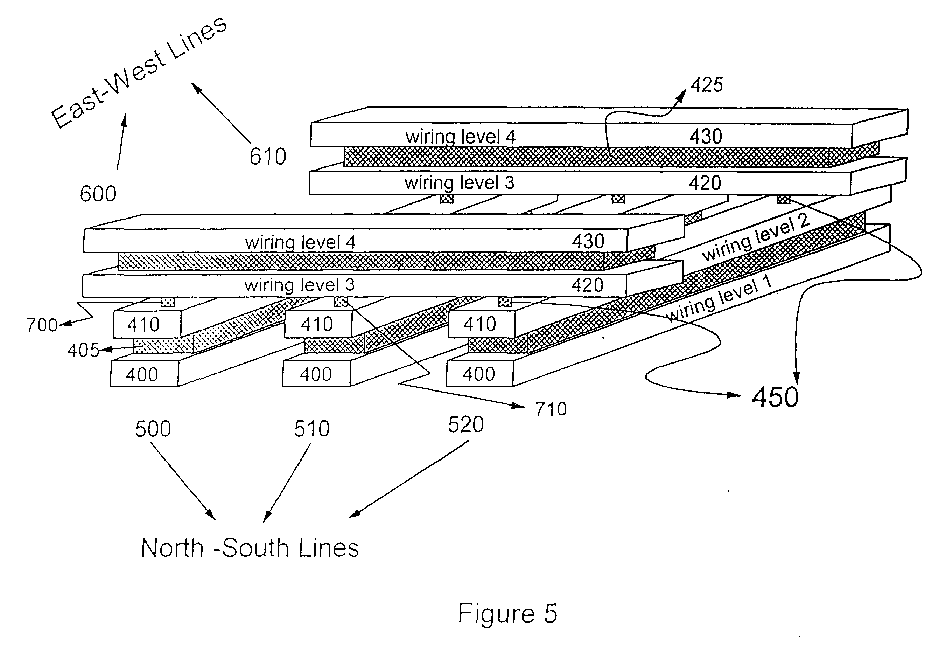

A third embodiment is shown in Figure 5, wherein the fuses are arranged in an array configuration. Herein, a "wall like" common terminal similar to the arrangement depicted in Figure 4 is used for both terminals or pads of the fuse. The fuse elements in an array layout are shown as 450. A four level metallization scheme is used to illustrate the fuse configuration. A set of orthogonal contact buses 500, 510 and 520 are shown running north-south. Each of these buses is made up of two wiring levels 400 and 410. The via level between them is replaced with a slotted contact 405 which is very much like the two lines above and below it and runs the length of the wires 400 and 410. Another set of contact buses 600 and 610 are shown running east-west, in a direction orthogonal to buses 500, 510 and 520. These buses also are made up of two wiring levels 420 and 430. As before, the via level between 420 and 430 is replaced with 425, which is again a slotted design running the length of lines 420 and 430. The fuses are positioned between levels 410 and 420 in the via level and are designated generically as 450. These fuses constitute the only electrical connection between the orthogonal buses. Vias 450 are shown herein as being all positioned in one level, i.e., between the second and the third wiring layer, although they are not limited to being coplanar. Fuses 450 can be standard electrical fuses or anti-fuses, as was explained in the Background of the Invention. One set of terminals is shown as wiring levels 400 and 410, with the interlevel via 405 running from north to south. The second set of terminals, shown as wiring levels 420 and 430, with the interlevel via 425 is shown running in an east-west direction. The two sets of terminals run orthogonal to each other, and the intersection of the two sets of terminals defines the preferred location of fuse array 450. As was previously described, the wiring and via levels are typically 0.2 to 0.5 um thick and about 2 um wide. Fuse 450 can be a standard electrical or anti-fuse.

The fuse blowing and addressing scheme will now be explained with reference to Figure 5. Referenced by numeral 700 is placed one particular fuse 450. To address and program this fuse, a voltage is applied between bus 500 and bus 600. Fuse 700 is the only fuse that will blow under these conditions because it is located at the intersection of the two aforementioned buses. In a second example, if the voltage were applied between bus 510 and bus 600, then only fuse 710 would be activated. Therefore, by selecting one north-south bus and one east-west bus only one fuse is addressed at a time, namely the fuse located at the intersection of the two buses.

In summary, in all three cases shown in Figures 3, 4 and 5, the wiring resistance typically ranges from a few tenths of ohms in lieu of the more typical tens of ohms typical of conventional fuse structures. Practitioners of the art will readily appreciate that in such instance when the fuse link resistance is typically of the order of 10-20 Ω, the external voltage needed to activate the fuse exceeds the voltage needed to program a fuse by a factor of two. The fuse configuration of the present invention thus represents a significant reduction in the magnitude of the voltage required to blow the fuses.

More particularly, with reference to Figures 3 and 4, the inventive fuse structure differs from standard vias or studs in the following aspects. The vias are replaced with slotted contacts wherein at least one dimension is four times and, preferably 8 to 10 times, the minimum feature size that is allowed for that wiring level in that technology. In Figure 4 the slots run the length of the lines above and below them and are therefore as long as the lines.

Whereas this invention has been described with reference to several embodiments, those skilled in the art will readily appreciate that various changes and modifications may be introduced without departing from the scope and the spirit of the invention.

**Claims**

1. An array of programmable fuses in a multi-layered structure, each of said programmable fuses having a fuse link terminating in a fuse pad at each end thereof, said array is characterized in that conductive stripes respectively short one of said fuse pads in each of said programmable fuses.

2. The array of programmable fuses as recited in claim 1, wherein said conductive stripes extend through each of said layers and providing a continuous and uniform conductive path linking said shorted fuse pads to a top layer of said multi-layered structure.

3. The array of programmable fuses as recited in claim 1, wherein the resistance of said conductive stripes is less than one ohms.

4. The array of programmable fuses as recited in claim 1, wherein the voltage required to program selected ones of said fuses is reduced in an inverse proportion to the dimensions of said conductive stripes.

5. A fuse buried inside a multi-layered structure, said fuse having a fuse link terminating in a fuse pad at each end thereof, said fuse is characterized in that conductive pads having dimensions equivalent to said fuse pads are stacked on said fuse pads.

6. The fuse as recited in claim 5, wherein said fuse pads are coupled to an upper layer of said multi-layered structure.

7. An array of co-planar programmable fuses buried in a multi-layered structure, each of said fuses having a fuse link terminating in a fuse pad at each end thereof, said array is characterized in that conductive pads with dimensions equivalent to said fuse pads are stacked on said fuse pads.

8. The array as recited in claim 7, wherein said conductive pads spanning through each of said layers provide an electrical path to said fuse pads and couple said fuse pads to an upper layer of said multi-layered structure.

9. An arrangement of co-planar programmable fuses buried in a multi-layered structure, said programmable fuses are configured in an array, said array of programmable fuses is positioned between orthogonally disposed contacts, each of said programmable fuses having a fuse link terminating in fuse pads, the arrangement of co-planar programmable fuses is characterized in that each row of said fuses is connected to conductive stripes at one end of each of said rows and is also connected to orthogonally positioned conductive stripes at a second end of said fuses, such that only one of said fuses is positioned between any two of said orthogonal conductive stripes.

10. The arrangement as recited in claim 9, wherein each of said fuses is programmed by applying a voltage across a pair of said orthogonal conductive stripes connecting respective pads of said fuse.

11. The arrangement of claim 9, wherein each of said conductive stripes below said array of fuses continuously extend through each of said layers below said fuse of said multi-layered structure providing a continuous and uniform conductive path linking said fuse pads to the bottommost layer of said multi-layer structure.

12. The arrangement of claim 9, wherein each of said conductive stripes above said array of fuses continuously extend through each of said layers above said fuse of said multi-layered structure providing a continuous and uniform conductive path linking said fuse pads to the topmost layer of said multi-layer structure.

$$V = V_F + V_1 + V_2$$

Figure 1

Figure 2 (Prior Art)

Figure 3

Figure 4

Figure 5

EP 1 045 441 A2